# EUROPEAN PATENT APPLICATION

(11) **EP 4 336 562 A1**
(43) Date of publication of application: **13.03.2024**
(21) Application number: 21955322.9
(22) Date of filing: 30.08.2021
(51) Int. Cl.: H01L 29/778, H01L 29/423

(54) **GALLIUM NITRIDE DEVICE AND MANUFACTURING METHOD THEREFOR, AND ELECTRONIC APPARATUS**

(71) Applicant: Huawei Technologies Co., Ltd., Longgang Shenzhen, Guangdong 518129 (CN)
(72) Inventor: TANG, Gaofei, Shenzhen, Guangdong 518129 (CN); UEDA, Daisuke, Shenzhen, Guangdong 518129 (CN); SUN, Hui, Shenzhen, Guangdong 518129 (CN); BAO, Qilong, Shenzhen, Guangdong 518129 (CN); WANG, Hanxing, Shenzhen, Guangdong 518129 (CN)
(74) Representative: Grünecker Patent- und Rechtsanwälte PartG mbB
(86) International application number: PCT/CN2021/115270
(87) International publication number: WO 2023/028740

(57) **Abstract**

Embodiments of this application disclose a gallium nitride component, a method for manufacturing a gallium nitride component, and an electronic device. The gallium nitride component may include a gallium nitride layer, a barrier layer on a surface of a side of the gallium nitride layer, and a gate on a side that is of the barrier layer and that is away from the gallium nitride layer. The gallium nitride layer has a gate region and a non-gate region outside the gate region. Elements of a constituent material of the barrier layer include aluminum (Al), gallium (Ga), and nitrogen (N). The barrier layer is located in the gate region and the non-gate region. In a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate. In this way, the aluminum concentration in the barrier layer decreases in a direction of the gate region away from the gallium nitride layer, and based on a polarization effect, the barrier layer can be naturally equivalent to p-type doping without Mg doping, so that electrons at an AlGaN/GaN interface in the gate region can be naturally exhausted, and a two-dimensional electron gas channel in the non-gate region is not exhausted. In addition, when a normally-closed gallium nitride component is formed, a defect state is not formed in the barrier layer in the non-gate region due to the Mg doping. Therefore, a risk of dynamic resistance degradation and resistance degradation after HTOL of the component is reduced, and the gallium nitride component with excellent performance is obtained.

## Description

### TECHNICAL FIELD

This application relates to the field of semiconductor manufacturing technologies, and in particular, to a gallium nitride component, a method for manufacturing a gallium nitride component, and an electronic device.

### BACKGROUND

With the development of power supply products toward high efficiency and miniaturization, a gallium nitride component, such as a power switch, prepared based on a wide band gap semiconductor material gallium nitride (GaN) is increasingly concerned.

Currently, the gallium nitride component mainly includes a component with a heterostructure based on aluminum gallium nitride (AlGaN)/GaN, for example, a high electron mobility transistor (HEMT). The heterostructure of the AlGaN/GaN can naturally form a high mobility two-dimensional electron gas (2-DEG) channel on an interface of the AlGaN/GaN. Therefore, the component prepared based on the heterostructure is a normally-open switch-type component. However, in an application field of switching power supply, a normally-closed gallium nitride component has advantages such as a compatible Si component driving scheme and a simple driving mode, and has more market value.

In a preparation process of the normally-closed gallium nitride component, a p-type GaN (p-GaN) layer may be grown on a surface of an AlGaN/GaN heterostructure of a gate region. The p-GaN layer exhausts a two-dimensional electron gas channel by doping magnesium (Mg) in an epitaxial growth process, and a non-gate region outside the gate region does not form p-GaN. In this way, the gate region has no channel, and the non-gate region has a channel. However, a current p-GaN-based normally-closed gallium nitride component has reliability problems such as serious dynamic resistance degradation and resistance degradation after a high temperature operating life (HTOL) test.

### SUMMARY

In view of this, embodiments of this application provide a gallium nitride component, a method for manufacturing a gallium nitride component, and an electronic device, to implement channel exhaustion by forming a new structure in a gate region, thereby reducing a risk of dynamic resistance degradation and resistance degradation after HTOL.

According to a first aspect of embodiments of this application, a gallium nitride component is provided, including a gallium nitride layer, a barrier layer on a surface of a side of the gallium nitride layer, and a gate on a side that is of the barrier layer and that is away from the gallium nitride layer. The gallium nitride layer has a gate region and a non-gate region outside the gate region. Elements of a constituent material of the barrier layer include aluminum (Al), gallium (Ga), and nitrogen (N). The barrier layer is located in the gate region and the non-gate region. In a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate. In this way, the aluminum concentration in the barrier layer decreases in a direction of the gate region away from the gallium nitride layer, and based on a polarization effect, the barrier layer can be naturally equivalent to p-type doping without Mg doping, so that electrons at an AlGaN/GaN interface in the gate region can be naturally exhausted, and a two-dimensional electron gas channel in the non-gate region is not exhausted. In addition, when a normally-closed gallium nitride component is formed, a defect state is not formed in the barrier layer in the non-gate region due to the Mg doping. Therefore, a risk of dynamic resistance degradation and resistance degradation after HTOL of the component is reduced, and the gallium nitride component with excellent performance is obtained.

In some possible implementations, the barrier layer includes a first part facing the gallium nitride layer and a second part facing the gate, aluminum concentration of the first part is greater than aluminum concentration of the second part, the first part is located in the gate region and the non-gate region, and a projection of the second part on the surface of the gallium nitride layer is located in the gate region.

In this embodiment of this application, the barrier layer may include the first part and the second part. The aluminum concentration of the first part is greater than that of the second part, and the second part is located on the first part of the gate region. The first part and the second part of the gate region may be naturally equivalent to p-type doping without Mg doping. This facilitates channel exhaustion in the gate region.

In some possible implementations, the first part is a first film layer, the second part includes a plurality of laminated sub-film layers, and aluminum concentration of sub-film layers facing the gate is less than aluminum concentration of sub-film layers facing the first part.

In this embodiment of this application, the first part is the first film layer, and the second part includes the plurality of laminated sub-film layers, so that the barrier layer can form a multi-layer structure, and concentration of the barrier layer sequentially decreases. This enhances a polarization effect of the barrier layer in the gate region, and facilitates aluminum concentration control and channel exhaustion in the gate region.

In some possible implementations, the aluminum concentration of the second part presents a descending trend from a side facing the first part to a side away from the first part.

In this embodiment of this application, the second part may be an integrated structure. The integrated structure does not have an obvious boundary, and internal aluminum concentration tends to decrease from a side facing the first part to a side away from the first part, so that the aluminum concentration is gradually disposed. This enhances a polarization effect of the barrier layer in the gate region, and facilitates aluminum concentration control and channel exhaustion in the gate region.

In some possible implementations, in the direction perpendicular to the surface of the gallium nitride layer, the size of the barrier layer located in the non-gate region is less than or equal to 30 nm.

In embodiments of this application, a thickness of the barrier layer in the non-gate region is small, so that a thickness of the barrier layer that is in the gate region and that can generate a two-dimensional electron gas is also small. This facilitates channel exhaustion in the gate region.

In some possible implementations, a mole ratio of aluminum to gallium in the barrier layer located in the non-gate region is greater than or equal to 3/7.

In this embodiment of this application, the mole ratio of aluminum to gallium in the barrier layer located in the non-gate region is greater than or equal to a preset value, so that the barrier layer in the non-gate region has large aluminum concentration. This helps generate sufficient two-dimensional electron gas between the barrier layer and an aluminum gallium nitride layer, and helps form a channel in the non-gate region.

In some possible implementations, the gallium nitride component further includes:
a source and a drain, where the source and the drain are located on a side that is of the barrier layer in the non-gate region and that is away from the gallium nitride layer.

In this embodiment of this application, the gallium nitride component further includes the source and the drain, which are respectively located on two sides of the gate and are configured to apply a source signal and a drain signal.

In some possible implementations, a material of at least one of the source, the drain, and the gate is at least one of: nickel, titanium, aluminum, palladium, platinum, gold, titanium nitride, tantalum nitride, and copper.

In this embodiment of this application, materials of the source, the drain, and the gate are relatively conductive materials, which helps improve component performance.

In some possible implementations, the gallium nitride component further includes:
a passivation layer, where the passivation layer covers the barrier layer located in the non-gate region.

In this embodiment of this application, the gallium nitride component further includes the passivation layer, configured to provide stress for the barrier layer, and promote regeneration of a two-dimensional electron gas channel in the non-gate region. This helps obtain a channel with a high charge transfer rate.

In some possible implementations, the passivation layer further covers the barrier layer located in the gate region, the gate includes a first gate structure and a second gate structure that are electrically connected, the first gate structure penetrates the passivation layer, and the second gate structure is formed on a side that is of the first gate structure and that is away from the gallium nitride layer, and covers a part of a surface of the passivation layer.

In embodiments of this application, the gate may include two parts, to form a "T"-shaped structure, to facilitate leading out of the gate.

In some possible implementations, a material of the passivation layer is at least one of silicon nitride and aluminum carbide.

In this embodiment of this application, the passivation layer is a material that can provide stress for the barrier layer, and facilitates channel regeneration in the non-gate region.

In some possible implementations, the gallium nitride component further includes:
a gate dielectric layer located between the barrier layer and the gate.

In this embodiment of this application, there may be the gate dielectric layer between the barrier layer and the gate. Compared with direct contact between the gate and the barrier layer, this reduces an interface defect, and improves threshold stability of the component.

In some possible implementations, the gallium nitride component further includes:
a substrate, located on a side that is of the gallium nitride layer and that is away from the barrier layer.

In this embodiment of this application, the gallium nitride layer may be disposed on the substrate, and the substrate is used to provide support for the gallium nitride layer.

In some possible implementations, the gallium nitride component further includes:
a buffer layer located between the substrate and the gallium nitride layer.

In this embodiment of this application, the buffer layer is formed between the gallium nitride layer and the substrate, which and facilitates forming the gallium nitride layer with good quality.

A second aspect of embodiments of this application provides a method for manufacturing a gallium nitride component, including:
obtaining a gallium nitride layer, where the gallium nitride layer has a gate region and a non-gate region outside the gate region; and
forming a barrier layer on a surface of a side of the gallium nitride layer, and a gate located on a side that is of the barrier layer in the gate region and that is away from the gallium nitride layer, where elements of a constituent material of the barrier layer include aluminum, gallium, and nitrogen, the barrier layer is located in the gate region and the non-gate region, and in a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate.

In some possible implementations, the barrier layer includes a first part facing the gallium nitride layer and a second part facing the gate, aluminum concentration of the first part is greater than aluminum concentration of the second part, the first part is located in the gate region and the non-gate region, and a projection of the second part on the surface of the gallium nitride layer is located in the gate region.

In some possible implementations, the first part is a first film layer, the second part includes a plurality of laminated sub-film layers, and aluminum concentration of sub-film layers facing the gate is less than aluminum concentration of sub-film layers facing the first part.

In some possible implementations, the aluminum concentration of the second part presents a descending trend from a side facing the first part to a side away from the first part.

In some possible implementations, in the direction perpendicular to the surface of the gallium nitride layer, the size of the barrier layer located in the non-gate region is less than or equal to 30 nm.

In some possible implementations, a mole ratio of aluminum to gallium in the barrier layer located in the non-gate region is greater than or equal to 3/7.

In some possible implementations, the method further includes:
forming a source and a drain on a side that is of the barrier layer in the non-gate region and that is away from the gallium nitride layer.

In some possible implementations, a material of at least one of the source, the drain, and the gate is at least one of: nickel, titanium, aluminum, palladium, platinum, gold, titanium nitride, tantalum nitride, and copper.

In some possible implementations, the forming a barrier layer on a surface of a side of the gallium nitride layer, and a gate located on a side that is of the barrier layer in the gate region and that is away from the gallium nitride layer includes:
forming an aluminum gallium nitride material layer on the surface of the side of the gallium nitride layer, where elements of a constituent material of the aluminum gallium nitride material layer include aluminum, gallium, and nitrogen, and aluminum concentration on a side that is of the aluminum gallium nitride material layer and that faces the gallium nitride layer is greater than aluminum concentration on a side that is of the aluminum gallium nitride material layer and that is away from the gallium nitride layer;
thinning the aluminum gallium nitride material layer located in the non-gate region, to obtain the barrier layer; and
forming the gate on the side that is of the barrier layer located in the gate region and that is away from the gallium nitride layer.

In some possible implementations, the forming the gate on the side that is of the barrier layer located in the gate region and that is away from the gallium nitride layer includes:
forming a passivation layer covering the barrier layer; and
etching the passivation layer that covers the barrier layer in the gate region, to form a gate hole that penetrates the passivation layer, and form the gate in the gate hole.

In some possible implementations, the gate includes a first gate structure and a second gate structure that are electrically connected, the first gate structure is located in the gate hole, and the second gate structure is formed on a side that is of the first gate structure and that is away from the gallium nitride layer, and covers a part of a surface of the passivation layer.

In some possible implementations, before the forming the gate, the method further includes:
forming a gate dielectric layer between the barrier layer and the gate.

In some possible implementations, the forming a barrier layer on a surface of a side of the gallium nitride layer, and a gate located on a side that is of the barrier layer in the gate region and that is away from the gallium nitride layer includes:
forming an aluminum gallium nitride material layer on the surface of the side of the gallium nitride layer, and a gate material layer located on a side that is of the aluminum gallium nitride material layer and that is away from the gallium nitride layer, where elements of a constituent material of the aluminum gallium nitride material layer include aluminum, gallium, and nitrogen, and aluminum concentration on a side that is of the aluminum gallium nitride material layer and that faces the gallium nitride layer is greater than aluminum concentration on a side that is of the aluminum gallium nitride material layer and that is away from the gallium nitride layer; and
etching the gate material layer located on a side that is of the aluminum gallium nitride material layer in the non-gate region and that is away from the gallium nitride layer, and thinning the aluminum gallium nitride material layer located in the non-gate region, to obtain the barrier layer and the gate located on the side that is of the barrier layer in the gate region and that is away from the gallium nitride layer.

In some possible implementations, the method further includes:
forming a gate medium material layer between the aluminum gallium nitride material layer and the gate material layer; and
when the gate material layer located on the side that is of the aluminum gallium nitride material layer in the non-gate region and that is away from the gallium nitride layer is etched, and the aluminum gallium nitride material layer located in the non-gate region is thinned, further etching the gate medium material layer located on a side that is of the aluminum gallium nitride material layer in the non-gate region and that is away from the gallium nitride layer, to obtain a gate dielectric layer located between the barrier layer and the gate.

In some possible implementations, after the forming the barrier layer, the method further includes:
forming a passivation layer covering the barrier layer.

In some possible implementations, a material of the passivation layer is at least one of silicon nitride and aluminum carbide.

In some possible implementations, a substrate is disposed on a side that is of the gallium nitride layer and that is away from the barrier layer.

In some possible implementations, a buffer layer is disposed between the gallium nitride layer and the substrate.

According to a third aspect of embodiments of this application, an electronic device is provided, including a circuit board and the gallium nitride component that is connected to the circuit board and that is provided in the first aspect of this application.

According to the foregoing technical solutions, it can be learned that embodiments of this application have the following advantages:

Embodiments of this application provide a gallium nitride component, a method for manufacturing a gallium nitride component, and an electronic device. The gallium nitride component may include a gallium nitride layer, a barrier layer on a surface of a side of the gallium nitride layer, and a gate on a side that is of the barrier layer and that is away from the gallium nitride layer. The gallium nitride layer has a gate region and a non-gate region outside the gate region. Elements of a constituent material of the barrier layer include aluminum (Al), gallium (Ga), and nitrogen (N). The barrier layer is located in the gate region and the non-gate region. In a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate. In this way, the aluminum concentration in the barrier layer decreases in a direction of the gate region away from the gallium nitride layer, and based on a polarization effect, the barrier layer can be naturally equivalent to p-type doping without Mg doping, so that electrons at an AlGaN/GaN interface in the gate region can be naturally exhausted, and a two-dimensional electron gas channel in the non-gate region is not exhausted. In addition, when a normally-closed gallium nitride component is formed, a defect state is not formed in the barrier layer in the non-gate region due to the Mg doping. Therefore, a risk of dynamic resistance degradation and resistance degradation after HTOL of the component is reduced, and the gallium nitride component with excellent performance is obtained.

### BRIEF DESCRIPTION OF DRAWINGS

To clearly understand specific implementations of this application, the following briefly describes accompanying drawings used for describing the specific implementations of this application. Apparently, the accompanying drawings show merely some embodiments of this application.
FIG. 1 is a schematic diagram of epitaxial growth of a p-GaN layer according to an embodiment of this application;
FIG. 2 is a schematic diagram of forming a p-GaN layer in a gate region according to an embodiment of this application;
FIG. 3 is a schematic diagram of a correlation relationship between a dynamic resistance of a component and Mg doping concentration according to an embodiment of this application;
FIG. 4 is a schematic diagram of a structure of a gallium nitride component according to an embodiment of this application;
FIG. 5 is a schematic diagram of a structure of a second part according to an embodiment of this application;
FIG. 6 is a schematic diagram of concentration distribution of a first part and a second part according to an embodiment of this application;
FIG. 7 is a schematic diagram of a barrier height of a gallium nitride layer and a barrier layer in a gate region according to an embodiment of this application;
FIG. 8 is a schematic diagram of a structure of another gallium nitride component according to an embodiment of this application;
FIG. 9 is a schematic diagram of a structure of still another gallium nitride component according to an embodiment of this application;
FIG. 10 is a schematic diagram of a structure of yet another gallium nitride component according to an embodiment of this application;
FIG. 11 is a flowchart of a method for manufacturing a gallium nitride component according to an embodiment of this application; and
FIG. 12 to 21 are schematic diagrams of a structure of a gallium nitride component in a manufacturing process according to an embodiment of this application.

### DESCRIPTION OF EMBODIMENTS

Embodiments of this application provide a gallium nitride component, a method for manufacturing a gallium nitride component, and an electronic device, to implement channel exhaustion by forming a new structure in a gate region, thereby reducing a risk of dynamic resistance degradation and resistance degradation after HTOL.

In the specification, claims, and accompanying drawings of this application, the terms "first", "second", "third", "fourth", and so on (if existent) are intended to distinguish between similar objects but do not necessarily indicate a specific order or sequence. It should be understood that the data termed in such a way are interchangeable in proper circumstances so that embodiments described herein can be implemented in other orders than the order illustrated or described herein. In addition, the terms "include" and "have" and any other variants thereof are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

This application is described in detail with reference to the schematic diagram. For ease of description, a sectional view of a component structure is partially enlarged not according to a general proportion when embodiments of this application are described in detail, and the schematic diagram is merely an example, and should not limit the protection scope of this application. In addition, a length, a width, and a depth of three-dimensional space should be included in an actual production.

At present, a component prepared based on an AlGaN/GaN heterostructure is usually a normally-open switch-type component. However, a normally-open gallium nitride component needs a stable conduction current to maintain conduction of the normally-open gallium nitride component, and a reverse voltage needs to be added to a gate to turn off the component. This feature is not conducive to a design of a drive circuit, and power consumption of the component is high. In fact, in an application field of switching power supply, a normally-closed gallium nitride component has advantages such as a compatible Si component driving scheme and a simple driving mode, and has more market value.

In a preparation process of the normally-closed gallium nitride component, a p-GaN layer may be formed on a surface of an AlGaN/GaN heterostructure of a gate region. The p-GaN layer exhausts a two-dimensional electron gas channel by doping Mg in an epitaxial growth process, and a non-gate region does not form p-GaN. In this way, the gate region has no channel, and the non-gate region has a channel.

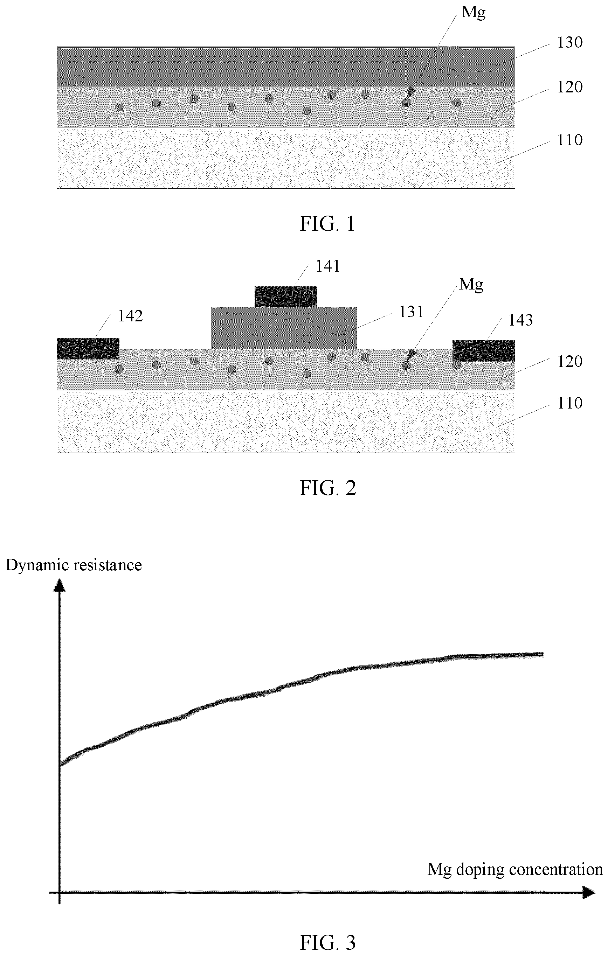

In an actual operation, the AlGaN/GaN heterostructure is formed in both the gate region and the non-gate region. In other words, both the gate region and the non-gate region have two-dimensional electron gas channels. To form the p-GaN layer on the surface of the AlGaN/GaN heterostructure in the gate region, a p-GaN material layer may be first epitaxially formed on AlGaN/GaN heterostructure surfaces of the gate region and the non-gate region. FIG. 1 is a schematic diagram of epitaxial growth of a p-GaN layer according to an embodiment of this application. An aluminum gallium nitride layer 120 is formed on a gallium nitride layer 110, and a two-dimensional electron gas (not shown) is formed between the gallium nitride layer 110 and the aluminum gallium nitride layer 120. A p-GaN material layer 130 is epitaxially formed on the aluminum gallium nitride layer 120, where Mg is doped in the p-GaN material layer 130. Then, the p-GaN material layer in the non-gate region is etched to restore a two-dimensional electron gas channel in a non-gate region, to form a p-GaN layer 131 located in a gate region. FIG. 2 is a schematic diagram of forming the p-GaN layer in the gate region according to an embodiment of this application. Then, a gate 141 may be formed on the p-GaN layer 131, and a source 142 and a drain 143 may be formed in the non-gate region. However, in an epitaxial growth process, Mg atoms used to form p-GaN also diffuse (out-diffuse) to an AlGaN barrier layer (namely, the aluminum gallium nitride layer 120), and introduces defect energy levels for the aluminum gallium nitride layer 120. As shown in FIG. 1 and FIG. 2, this causes electrons to be captured by these defect energy levels in a high voltage switching process of the component. As a result, reliability problems such as dynamic resistance degradation and resistance degradation after HTOL of the component are caused.

The dynamic resistance degradation of the component is strongly related to Mg doping concentration. Higher Mg doping concentration in the p-GaN indicates more serious dynamic resistance degradation of the component. FIG. 3 is a schematic diagram of a correlation relationship between a dynamic resistance of a component and Mg doping concentration according to an embodiment of this application. A horizontal coordinate is the Mg doping concentration, and a vertical coordinate is the dynamic resistance of the component. It can be learned from the figure that, higher Mg doping concentration indicates more serious dynamic resistance degradation of the component. The dynamic resistance degradation can be reduced by reducing the Mg concentration, but a threshold voltage of the component also decreases accordingly, which is unfavorable to a switch application scenario. Therefore, how to implement exhaustion of a two-dimensional electron gas channel in a gate region without affecting a dynamic resistance of a component is an urgent problem to be resolved in this field.

To resolve the foregoing technical problem, embodiments of this application provide a gallium nitride component, a method for manufacturing a gallium nitride component, and an electronic device. The gallium nitride component may include a gallium nitride layer, a barrier layer on a surface of a side of the gallium nitride layer, and a gate on a side that is of the barrier layer and that is away from the gallium nitride layer. The gallium nitride layer has a gate region and a non-gate region outside the gate region. Elements of a constituent material of the barrier layer include aluminum, gallium, and nitrogen. The barrier layer is located in the gate region and the non-gate region. In a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate. In this way, the aluminum concentration in the barrier layer decreases in a direction of the gate region away from the gallium nitride layer, and based on a polarization effect, the barrier layer can be naturally equivalent to p-type doping without Mg doping, so that electrons at an AlGaN/GaN interface in the gate region can be naturally exhausted, and a two-dimensional electron gas channel in the non-gate region is not exhausted. In addition, when a normally-closed gallium nitride component is formed, a defect state is not formed in the barrier layer in the non-gate region due to the Mg doping. Therefore, a risk of dynamic resistance degradation and resistance degradation after HTOL of the component is reduced, and the gallium nitride component with excellent performance is obtained.

To make the objectives, features, and advantages of this application more apparent and understandable, the following describes specific implementations of this application in detail with reference to the accompanying drawings.

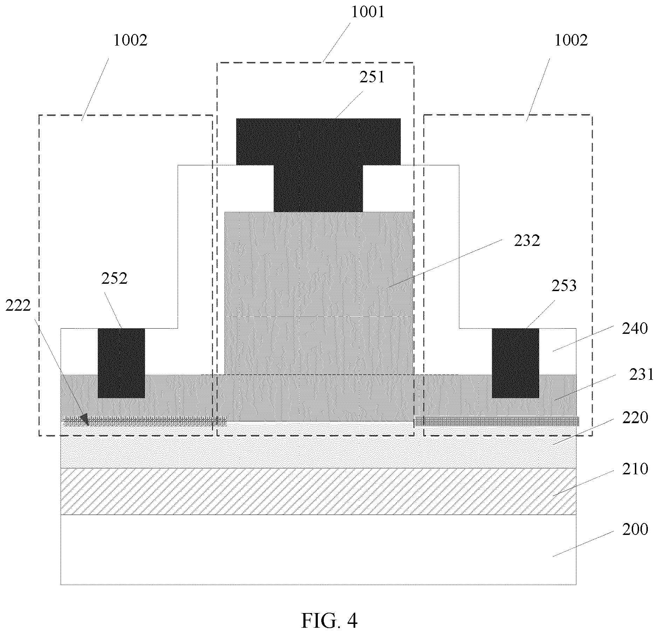

FIG. 4 is a schematic diagram of a structure of a gallium nitride component according to an embodiment of this application. The gallium nitride component includes a gallium nitride layer 220, a barrier layer 231&232, and a gate 251. The barrier layer 231&232 is located on a surface of a side of the gallium nitride layer 220, and elements of a constituent material of the barrier layer 231&232 include aluminum, gallium, and nitrogen, and the constituent material of the barrier layer 231&232 may be represented as aluminum gallium nitrogen (AlₓGa₁₋ₓN). The gallium nitride layer 220, and the barrier layer 231&232 whose material is aluminum gallium nitrogen form an AlGaN/GaN heterostructure, to generate a two-dimensional electron gas. Based on this, the formed gallium nitride component may operate by using the two-dimensional electron gas generated by the heterostructure. The gallium nitride component may be, for example, a high electron mobility transistor (HEMT) component based on gallium nitride.

In a possible implementation, a thickness of the gallium nitride layer 220 may be large. In this case, the gallium nitride layer 220 may be a substrate whose material is gallium nitride. The substrate provides a support function for a film layer on substrate, and is also used as a component of the AlGaN/GaN heterostructure.

In another possible implementation, the gallium nitride layer 220 may be thin. In this case, the gallium nitride layer 220 may be formed on a substrate 200. The substrate 200 is disposed on a side that is of the gallium nitride layer and that is away from the barrier layer 231&232. The substrate 200 provides a support function for a film layer on the substrate 200. The gallium nitride layer 220 is used as a component of the AlGaN/GaN heterostructure, and a material of the substrate 200 may be one or more of aluminum nitride (AIN), silicon (Si), silicon carbide (SiC), and sapphire. Optionally, a buffer layer 210 may be further disposed between the substrate 200 and the gallium nitride layer 220. A material of the buffer layer 210 may be aluminum nitride, or may be gallium nitride growing at a low temperature. When the buffer layer 210 is gallium nitride growing at a low temperature, the gallium nitride layer 220 may be a gallium nitride layer growing at a high temperature. In this way, the low-temperature gallium nitride layer is used as the buffer layer 210 between the high-temperature gallium nitride layer and the substrate 200, to improve epitaxial quality of the high-temperature gallium nitride layer.

The gallium nitride layer 220 may have a gate region 1001 and a non-gate region 1002 outside the gate region 1001. The gate region 1001 and the non-gate region 1002 are regions on a surface of the gallium nitride layer 220, and include space defined by the surface of the gallium nitride layer 220 and numerous straight lines perpendicular to the gallium nitride layer 220. For ease of description, a direction parallel to the surface of the gallium nitride layer 220 is used as a horizontal direction, a direction perpendicular to the surface of the gallium nitride layer 220 is used as a vertical direction. The gate region 1001 is used to form a gate 251, and may be a central region between regions in which a source 252 and a drain 253 are located. The gate region 1001 may be greater than a region in which the gate 251 is located, or may be equal to a region in which the gate 251 is located. In FIG. 4, a dashed box in the middle represents the gate region 1001, and dashed boxes on two sides of the gate region 1001 represent the non-gate region 1002. A same representation manner is used in a subsequent schematic diagram of a structure. Because FIG. 4 is a sectional view, the non-gate region 1002 may be actually located on two sides of the gate region 1001, or an annular region surrounding the gate region 1001, for example, an annular region or a polygon region.

In this embodiment of this application, the barrier layer 231&232 is located in the gate region 1001 and the non-gate region 1002. In a direction (namely, the vertical direction) perpendicular to the surface of the gallium nitride layer 220, a size of the barrier layer located in the gate region 1001 is greater than a size of the barrier layer located in the non-gate region 1002. In addition, aluminum concentration on a side that is of the barrier layer in the gate region 1001 and that faces the gallium nitride layer 220 is greater than aluminum concentration on a side that is of the barrier layer in the gate region 1001 and that faces the gate 251.

The aluminum concentration on the side that is of the barrier layer in the gate region 1001 and that faces the gallium nitride layer 220 is greater than the aluminum concentration on the side that is of the barrier layer in the gate region 1001 and that faces the gate 251. Correspondingly, gallium concentration on the side that is of the barrier layer in the gate region 1001 and that faces the gallium nitride layer 220 is greater than gallium concentration on the side that is of the barrier layer in the gate region 1001 and that faces the gate 251. Because this setting located in the gate region 1001, in the gate region 1001, aluminum components are reduced from the side facing the gallium nitride layer 220 to the side facing the gate 251. A part having lower aluminum components has a lower barrier height. Therefore, a low barrier exists between the part having lower aluminum components and the gallium nitride layer 220. In this structure, the aluminum components are reduced from the side facing the gallium nitride layer 220 to the side facing the gate 251. Because a polarization effect generates a hole in the barrier layer 231&232, the barrier layer 231&232 in the gate region 1001 may be naturally equivalent to p-type doping without Mg doping, a quantity of holes is basically equal to a quantity of electrons in a two-dimensional electron gas channel 222 in the gate region 1001, and the electrons in the two-dimensional electron gas channel 222 may be naturally exhausted.

In addition, in the p-GaN solution, hole concentration is strongly related to activation of Mg, and therefore parameters such as an activation temperature and doping concentration of the p-GaN need to be precisely controlled. Compared with the p-GaN solution, in this embodiment of this application, holes are generated by the polarization effect, and the quantity of holes is basically equal to the quantity of electrons in the two-dimensional electron gas channel 222 in the gate region 1001, and there is no problem that activation of holes in an Mg doping technology needs to be precisely controlled. In addition, because there is no p-GaN layer, there is no problem of a defect state caused by Mg diffusion. In addition, a threshold voltage of the component is determined by a structure of the gate region 1001, and a process window is large. Therefore, there is no problem that the threshold voltage is sensitive to Mg doping concentration and a p-GaN activation condition.

Specifically, the barrier layer 231&232 may include a first part 231 facing the gallium nitride layer 220 and a second part 232 facing the gate 251. The first part 231 is formed in the gate region 1001 and the non-gate region 1002, and a projection of the second part 232 on the surface of the gallium nitride layer 220 is located in the gate region. In other words, the second part 232 is formed in the first part 231 of the gate region 1001, and it may be considered that the second part 232 is formed in the gate region 1001. For ease of description, a sub-interface is disposed between the first part 231 and the second part 232, and the sub-interface is a plane on which an upper surface of the first part 231 is located. In the sectional view of FIG. 4, the sub-interface is represented as a division line, and the division line is a straight line on which the upper surface of the first part 231 is located, and is represented by a horizontal dashed line. In other words, the first part 231 and the second part 232 are separated by using the horizontal dashed line. A same representation manner is used in a subsequent schematic diagram of a structure. In other words, the barrier layer may be divided into the first part 231 and the second part 232 in the vertical direction, and the second part 232 covers the first part 231 located in the gate region 1001. The first part 231 and the second part 232 are defined for ease of description, and do not necessarily have a clear boundary. Subsequently, the first part 231 and the second part 232 are used to represent different parts of the barrier layer, and a surface of the first part 231 and a surface of the second part 232 are used to represent a surface of the barrier layer, where the second part 232 covers the surface of the first part 231 of the gate region 1001.

Aluminum concentration in the first part 231 is greater than aluminum concentration in the second part 232, and correspondingly, gallium concentration in the first part 231 is greaterthan gallium concentration in the second part 232. Because the second part 232 is formed in the gate region 1001, in the gate region 1001, aluminum components are reduced from the first part 231 to the second part 232. A part having lower aluminum components has a lower barrier height. Therefore, a low barrier between the part with the lower aluminum components and the gallium nitride layer 220. In this structure, the aluminum components are reduced from the first part 231 to the second part 232. Because a polarization effect generates a hole in the first part 231 and the second part 232, the barrier layer 231&232 in the gate region 1001 may be naturally equivalent to p-type doping without Mg doping, a quantity of holes is basically equal to a quantity of electrons in a two-dimensional electron gas channel 222 in the gate region 1001, and the electrons in the two-dimensional electron gas channel 222 may be naturally exhausted.

In this embodiment of this application, that the aluminum concentration in the first part 231 is greater than the aluminum concentration in the second part 232 may be reflected as that average aluminum concentration in the first part 231 is greater than average aluminum concentration in the second part 232, and the aluminum concentration in the second part 232 may be uniform or uneven.

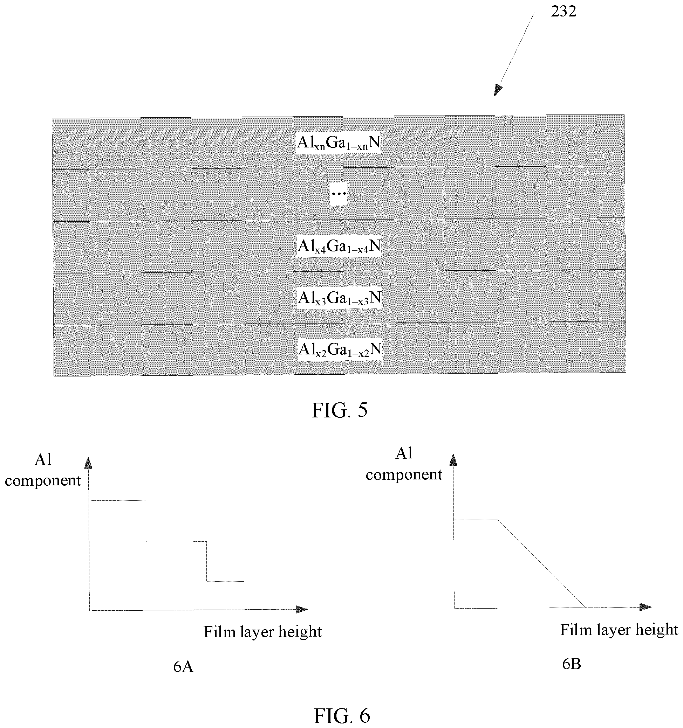

Specifically, the second part 232 may include a plurality of laminated sub-film layers, and the plurality of sub-film layers are laminated in the vertical direction. Aluminum concentration of the plurality of sub-film layers may not be exactly the same. Aluminum concentration of sub-film layers facing the gate 251 is less than aluminum concentration of sub-film layers facing the first part. In other words, aluminum concentration of upper sub-film layers may be less than aluminum concentration of lower sub-film layers. In this way, the aluminum concentration sequentially decreases from a side facing the first part 231 to a side away from the first part 231, and aluminum concentration of each sub-film layer presents a decreasing trend, so that the aluminum concentration decreases in a stepwise manner, and the polarization effect in the barrier layer 231&232 in the gate region 1001 is enhanced. For example, FIG. 5 is a schematic diagram of a structure of a second part according to an embodiment of this application. The second part 232 may include laminated n-1 sub-film layers. In addition, the first part 231 may be a first film layer (not shown in FIG. 5). To be specific, the barrier layer 231&232 in the gate region 1001 include n film layers in total, where n>2. Components of the first part 231 are represented as Alₓ₁Ga₁₋ₓ₁N. From a side facing the first part 231 to a side away from the first part 231, components of the sub-film layers are sequentially represented as Alₓ₂Ga₁₋ₓ₂N, Alₓ₃Ga₁₋ₓ₃N, Alₓ₄Ga₁₋ₓ₄N, ..., AlₓₙGa₁₋ₓₙN, where 1≥x1>x2≥x3...≥xn>0. When x1=1, a material of a corresponding first part 231 is AlN. When xn=0, a material of a corresponding sub-film layer is GaN.

FIG. 6 is a schematic diagram of concentration distribution of a first part and a second part according to an embodiment of this application. A horizontal coordinate represents a height of a film layer. An interface between the first part 231 and the gallium nitride layer 220 is used as a height zero, and a height of the film layer gradually increases from the side facing the first part 231 to the side away from the first part 231. A vertical coordinate represents content of an Al component. As shown in FIG. 6A, content of an aluminum component at different film layer heights inside each sub-film layer is the same. From the side facing the first part 231 to the side away from the first part 231, the content of the Al component decreases in a stepwise manner, which is represented as a stepwise decrease of x1, x2, x3, x4, ..., and xn. Certainly, from the side facing the first part 231 to the side away from the first part 231, aluminum concentration in the plurality of sub-film layers may not strictly decrease sequentially. Aluminum concentration in a small quantity of sub-film layers may alternatively be slightly increased. In other words, aluminum concentration of some upper sub-film layers may be greater than aluminum concentration of lower sub-film layers.

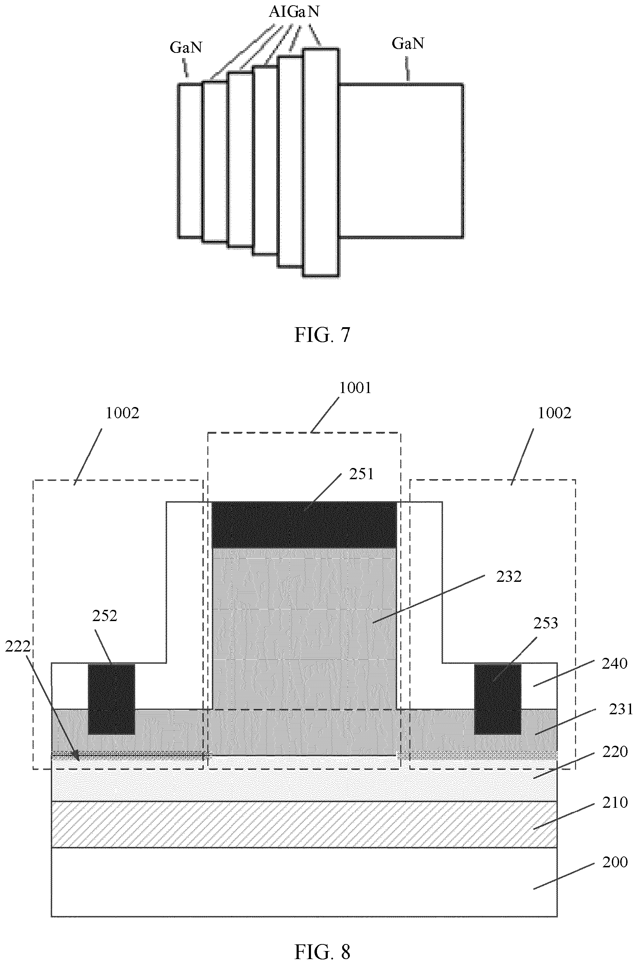

Because a part with low aluminum components has a low barrier height, a barrier height of the second part 232 gradually decreases from the side facing the first part 231 to the side away from the first part 231. When the second part 232 includes a plurality of laminated sub-film layers in the vertical direction, and aluminum concentration of the plurality of sub-film layers decreases in a stepwise manner, the barrier height of the second part 232 also decreases in a stepwise manner. FIG. 7 is a schematic diagram of a barrier height of a gallium nitride layer and a barrier layer in a gate region according to an embodiment of this application. An example in which n is 6 is used for description, and x6=0. The gallium nitride layer (GaN) 220, the first part (Alₓ₁Ga₁₋ₓ₁N) 231, and the second part (Alₓ₂Ga₁₋ₓ₂N, Alₓ₃Ga₁₋ₓ₃N, Alₓ₄Ga₁₋ₓ₄N, Alₓ₅Ga₁₋ₓ₅N, GaN) 232 are sequentially arranged from right to left, where Alₓ₁Ga₁₋ₓ₁N, Alₓ₂Ga₁₋ₓ₂N, Alₓ₃Ga₁₋ₓ₃N, Alₓ₄Ga₁₋ₓ₄N, and Alₓ₅Ga₁₋ₓ₅N are jointly represented as AlGaN. In a direction from right to left, barrier heights of the second part 232 sequentially decrease. In this way, a quantity of holes generated on a side that is of the first part 231 and that is away from the gallium nitride layer 220 is represented as *σ*_{*p*1}, and quantities of holes generated in the second part 232 are sequentially represented as *σ*_{*p*2}, *σ*_{*p*3,} *σ*_{*p*4}, *σ*_{*p*5}, and *σ*_{*p*6}, where *σ*_{*p*1}, *σ*_{*p*2}, *σ*_{*p*3,} *σ*_{*p*4}, *σ*_{*p*5}, and *σ*_{*p*6} sequentially increase. A quantity of holes *σₙ* generated in the barrier layer 231&232 in the gate region 1001 is a sum of *σ*_{*p*1}, *σ*_{*p*2}, *σ*_{*p*3,} *σ*_{*p*4}, *σ*_{*p*5}, and *σ*_{*p*6}, and is basically the same as a quantity of electrons that are generated between the first part (Alₓ₁Ga₁₋ₓ₁N) 231 and the gallium nitride layer (GaN) 220 and that are located in the two-dimensional electron gas channel 222 in the gate region 1001.

Specifically, the second part 232 may alternatively be an integrated structure without an obvious boundary, that is, there may be no obvious sudden change in aluminum content in the second part 232, and the aluminum concentration of the second part 232 presents a descending trend from the side facing the first part 231 to the side away from the first part 231. The descending trend may be continuous and uniform decline, or may be non-uniform decline. As shown in FIG. 6B, aluminum concentration at different film layer heights inside the first part 231 is the same, and the aluminum concentration of the second part 232 decrease at a uniform speed from the side facing the first part 231 to the side away from the first part 231. Certainly, the aluminum concentration of the second part 232 may further increase slightly at a small quantity of positions from the side facing the first part 231 to the side away from the first part 231. In addition, the first part 231 and the second part 232 may alternatively be an integrated structure without an obvious boundary, and aluminum in the first part 231 is evenly distributed.

In this embodiment of this application, a mole ratio of aluminum to gallium in the barrier layer located in the non-gate region is greater than or equal to 3/7. In other words, a mole ratio of aluminum to gallium in the first part 231 is greater than or equal to 3/7, that is, x1≥30%. Therefore, the first part 231 has a high barrier height, and can effectively generate a two-dimensional electron gas.

In this embodiment of this application, the two-dimensional electron gas channel 222 generated between the aluminum gallium nitride layer and the gallium nitride layer 220 with a low thickness is easily exhausted. Therefore, the first part 231 may be set to have a small thickness. Specifically, a size (namely, a vertical size) of the first part 231 (namely, the barrier layer in the non-gate region 1002) in a direction perpendicular to the surface of the gallium nitride layer 220 may be less than or equal to 30 nm, for example, 5 nm. When a vertical size of the first part 231 is small, a passivation layer 240 may be further formed on a surface of the first part 231 (namely, a surface of the barrier layer in the non-gate region 1001) to generate stress, so that the two-dimensional electron gas channel 222 in the first part 231 is regenerated, which helps implement a channel with a high charge transfer rate, as shown in FIG. 4. The passivation layer 240 covers the barrier layer (namely, the first part 231) in the non-gate region 1002, and may further cover the barrier layer (namely, the second part 232) in the gate region 1001. For example, the second part 232 covers the first part 231 of the gate region 1001, and covers a side wall of the second part 232. The passivation layer 240 may further cover a part of an upper surface of the second part 232. A material of the passivation layer 240 may be at least one of silicon nitride and aluminum carbide.

In this embodiment of this application, the gate 251 is formed on a side that is of the barrier layer 231&232 in the gate region 1001 and that is away from the gallium nitride layer 220, that is, is formed on the second part 232.

In some possible implementations, a part of an upper surface of the second part 232 is covered with the passivation layer 240, and the gate 251 may penetrate the passivation layer 240 that covers the second part 232, as shown in FIG. 4. In some possible implementations, the gate 251 may include a first gate structure and a second gate structure that are electrically connected, the first gate structure penetrates the passivation layer 240, and the second gate structure is formed on a side that is of the first gate structure and that is away from the substrate 200, and covers a part of a surface of the passivation layer 240. In other words, the gate 251 may form a "T"-shaped structure. As shown in FIG. 4, the gate 251 may cover a part of the upper surface of the second part 232, and cover a part of the upper surface of the passivation layer 240, so that the gate 251 can be easily led out.

In some other possible implementations, the gate 251 may alternatively cover an entire upper surface of the second part 232, to form a surface-like structure, and side walls of the gate 251 and the second part 232 may be flush. FIG. 8 is a schematic diagram of a structure of another gallium nitride component according to an embodiment of this application. The passivation layer may cover a side wall of the gate 251.

In this embodiment of this application, the gate 251 may be in direct contact with the second part 232, to form a Schottky gate component structure. As shown in FIG. 4 and FIG. 8, compared with a solution in which the gate 251 is in contact with the first part 231, in a solution in which the gate 251 is in contact with the second part 232, a forward leakage current of the component is reduced.

In this embodiment of this application, a gate dielectric layer 260 may also be formed between the gate 251 and the second part 232 of the barrier layer, to form an insulated gate component structure. Compared with a solution in which the gate 251 is in contact with the first part 231 with higher aluminum concentration and the gate dielectric layer 260 is in direct contact with the first part 231 with higher aluminum concentration, a solution in which the gate 251 is in contact with the gate dielectric layer 260 and the gate dielectric layer 260 is in contact with the second part 232 reduces an interface defect, and improves threshold stability of the component.

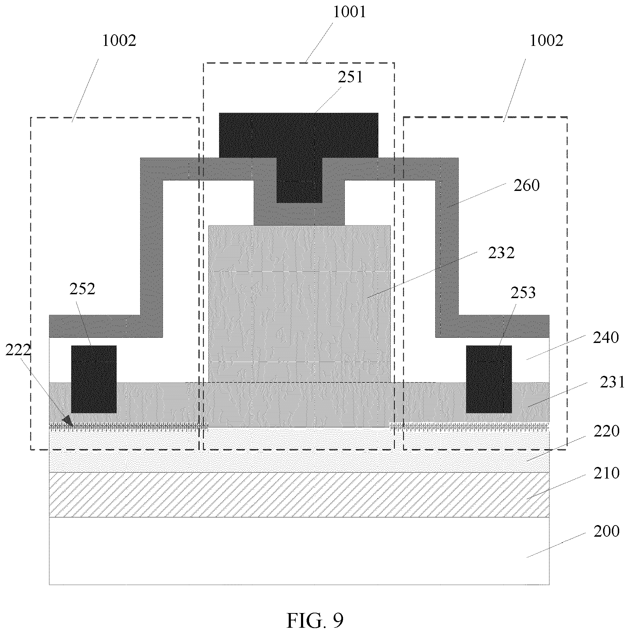

In some possible implementations, FIG. 9 is a schematic diagram of a structure of still another gallium nitride component according to an embodiment of this application. FIG. 9 is a schematic diagram of a gallium nitride structure obtained after a gate dielectric layer 260 is added on the basis of the gallium nitride structure in FIG. 4. The gate 251 includes a first gate structure and a second gate structure that are electrically connected, and the gate dielectric layer 260 is formed between the gate 251 and the second part 232, to cover a part of the upper surface of the second part 232. The gate dielectric layer 260 may further be formed between the gate 251 and the passivation layer 240, to cover a side wall that is of the passivation layer 240 and that faces the gate 251. Certainly, the gate dielectric layer 260 may further cover a side wall that is of the passivation layer 240 and that is away from the gate 251, and cover a part of a surface of the first part 231.

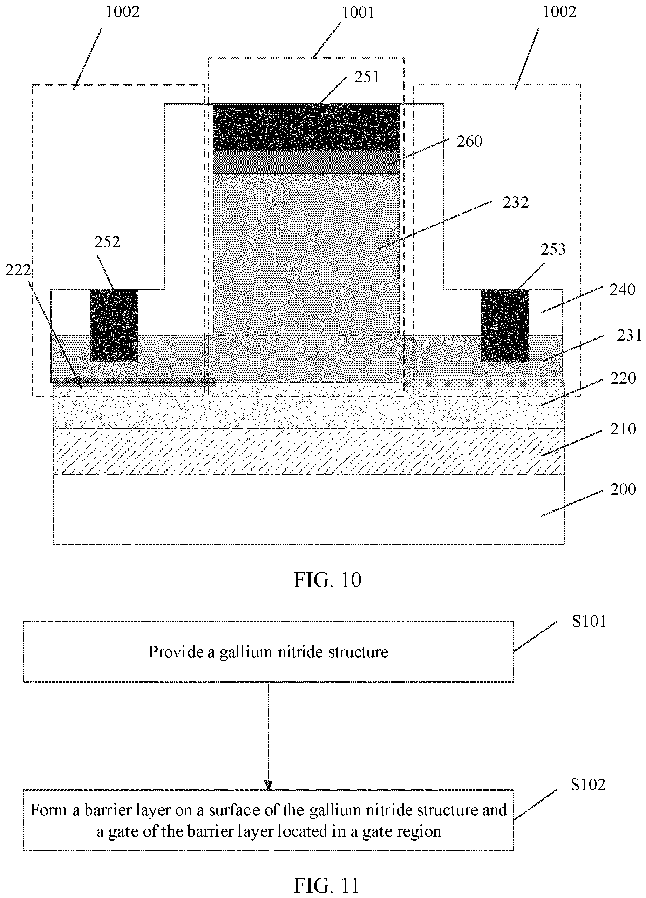

In some other possible implementations, FIG. 10 is a schematic diagram of a structure of yet another gallium nitride component according to an embodiment of this application. FIG. 10 is a schematic diagram of a gallium nitride structure obtained after a gate dielectric layer 260 is added on the basis of the gallium nitride structure in FIG. 8. The gate dielectric layer 260 covers an entire upper surface of the second part 232, and the gate 251 covers an entire upper surface of the gate dielectric layer 260. The passivation layer 240 may cover a side wall of the gate dielectric layer 260, and may further cover a side wall of the gate 251.

In this embodiment of this application, the gallium nitride component may further include a source 252 and a drain 253. The source 252 and the drain 253 are located on a side that is of the barrier layer in the non-gate region 1002 and that is away from the gallium nitride layer 220, that is, located on the first part 231. The source 252 and the drain 253 are respectively located on two sides of the gate 251. The source 252, the drain 253, and the gate 251 all use materials with good conductivity, and a material of at least one of the source 252, the drain 253, and the gate 251 is at least one of: nickel, titanium, aluminum, palladium, platinum, gold, titanium nitride, tantalum nitride, and copper.

Embodiments of this application provide a gallium nitride component. The gallium nitride component may include a gallium nitride layer, a barrier layer on a surface of the gallium nitride layer, and a gate on a side that is of the barrier layer and that is away from the gallium nitride layer. The gallium nitride layer has a gate region and a non-gate region outside the gate region. Elements of a constituent material of the barrier layer include aluminum, gallium, and nitrogen. The barrier layer is located in the gate region and the non-gate region. In a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate. In this way, the aluminum concentration in the barrier layer decreases in a direction of the gate region away from the gallium nitride layer, and based on a polarization effect, the barrier layer can be naturally equivalent to p-type doping without Mg doping, so that electrons at an AlGaN/GaN interface in the gate region can be naturally exhausted, and a two-dimensional electron gas channel in the non-gate region is not exhausted. In addition, when a normally-closed gallium nitride component is formed, a defect state is not formed in the barrier layer in the non-gate region due to the Mg doping. Therefore, a risk of dynamic resistance degradation and resistance degradation after HTOL of the component is reduced, and the gallium nitride component with excellent performance is obtained.

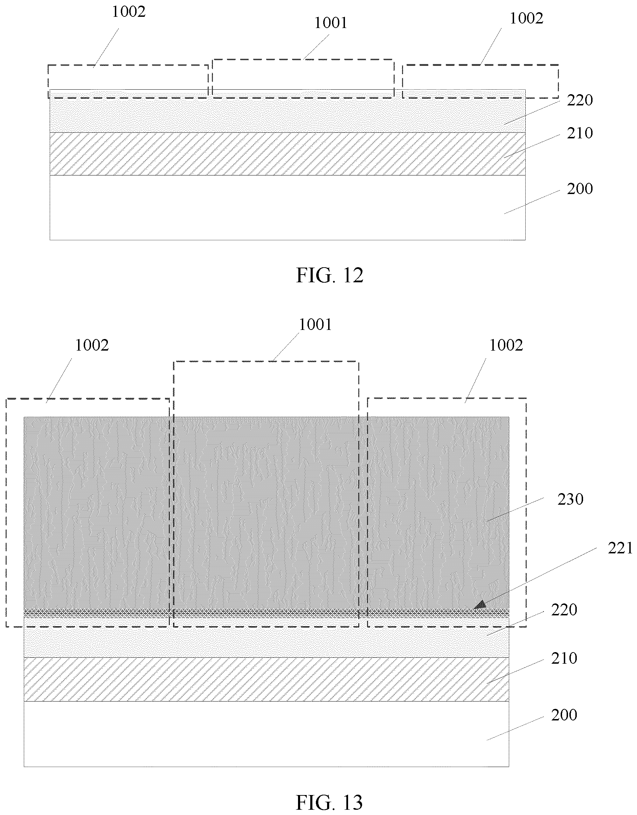

Based on the gallium nitride component provided in embodiments of this application, an embodiment of this application further provides a method for manufacturing a gallium nitride component. FIG. 11 is a flowchart of a method for manufacturing a gallium nitride component according to an embodiment of this application. FIG. 12 to FIG. 21 are schematic diagrams of a structure of a gallium nitride component in a manufacturing process according to an embodiment of this application. The manufacturing method may include the following steps.

S101: Obtain a gallium nitride layer 220, as shown in FIG. 12.

In a possible implementation, a thickness of the gallium nitride layer 220 may be large. In this case, the gallium nitride layer 220 may be a substrate whose material is gallium nitride. The substrate provides a support function for a film layer on the substrate, and is also used as a component of the AlGaN/GaN heterostructure.

In another possible implementation, the gallium nitride layer 220 may be thin. As shown in FIG. 12, the gallium nitride layer 220 may be formed on a substrate 200. The substrate 200 provides a support function for a film layer on the substrate 200. The gallium nitride layer 220 is used as a component of an AlGaN/GaN heterostructure, and a material of the substrate 200 may be one or more of aluminum nitride (AIN), silicon (Si), silicon carbide (SiC), and sapphire. Optionally, a buffer layer 210 may be further disposed between the substrate 200 and the gallium nitride layer 220, and a material of the buffer layer 210 may be aluminum nitride, or may be gallium nitride growing at a low temperature.

During specific implementation, the buffer layer 210 may be first formed on a surface of the substrate 200, and then the gallium nitride layer 220 is formed on the buffer layer 210. The gallium nitride layer 220 may be formed in a metal organic chemical vapor deposition (MOCVD) manner.

The gallium nitride layer 220 may have a gate region 1001 and a non-gate region 1002 outside the gate region 1001, and the gate region 1001 and the non-gate region 1002 are regions on a surface of the gallium nitride layer 220. The gate region 1001 is used to form a gate 251, and may be a central region between regions in which a source 252 and a drain 253 are located. The gate region 1001 may be greater than or equal to a region in which the gate 251 is located. As shown in FIG. 12, a dashed box in the middle represents the gate region 1001, and dashed boxes on two sides of the gate region 1001 represent the non-gate region 1002.

S102: Form a barrier layer 231&232 on a surface of a side of the gallium nitride layer 220, and a gate 251 on a side that is of the barrier layer 231&232 located in the gate region 1001 and that is away from the gallium nitride layer 220, as shown in FIG. 13 to FIG. 21.

In this embodiment of this application, the barrier layer 231&232 may be formed on the surface of the gallium nitride layer 220. The barrier layer 231&232 is located on the surface of the side of the gallium nitride layer 220, and elements of a constituent material of the barrier layer 231&232 include aluminum, gallium, and nitrogen, and the constituent material of the barrier layer 231&232 may be represented as aluminum gallium nitrogen (AlₓGa₁₋ₓN). The gallium nitride layer 220, and the barrier layer 231&232 whose material is aluminum gallium nitrogen form an AlGaN/GaN heterostructure, to generate a two-dimensional electron gas. Based on this, the formed gallium nitride component may operate by using the two-dimensional electron gas generated by the heterostructure. When the gallium nitride layer 220 is disposed on the substrate 200, the barrier layer 231&232 is disposed on a side that is of the gallium nitride layer 220 and that is away from the substrate 200.

In this embodiment of this application, the barrier layer 231&232 is located in the gate region 1001 and the non-gate region 1002. In a direction (namely, the vertical direction) perpendicular to the surface of the gallium nitride layer 220, a size of the barrier layer located in the gate region 1001 is greater than a size of the barrier layer located in the non-gate region 1002. In addition, aluminum concentration on a side that is of the barrier layer in the gate region 1001 and that faces the gallium nitride layer 220 is greater than aluminum concentration on a side that is of the barrier layer in the gate region 1001 and that faces the gate 251.

The aluminum concentration on the side that is of the barrier layer in the gate region 1001 and that faces the gallium nitride layer 220 is greater than the aluminum concentration on the side that is of the barrier layer in the gate region 1001 and that faces the gate 251. Correspondingly, gallium concentration on the side that is of the barrier layer in the gate region 1001 and that faces the gallium nitride layer 220 is greater than gallium concentration on the side that is of the barrier layer in the gate region 1001 and that faces the gate 251. Because this setting located in the gate region 1001, in the gate region 1001, aluminum components are reduced from the side facing the gallium nitride layer 220 to the side facing the gate 251. A part having lower aluminum components has a lower barrier height. Therefore, a low barrier exists between the part having lower aluminum components and the gallium nitride layer 220. In this structure, the aluminum components are reduced from the side facing the gallium nitride layer 220 to the side facing the gate 251. Because a polarization effect generates a hole in the barrier layer 231&232, the barrier layer 231&232 in the gate region 1001 may be naturally equivalent to p-type doping without Mg doping, a quantity of holes is basically equal to a quantity of electrons in a two-dimensional electron gas channel 222 in the gate region 1001, and the electrons in the two-dimensional electron gas channel 222 may be naturally exhausted.

In addition, in the p-GaN solution, hole concentration is strongly related to activation of Mg, and therefore parameters such as an activation temperature and doping concentration of the p-GaN need to be precisely controlled. Compared with the p-GaN solution, in this embodiment of this application, holes are generated by the polarization effect, and the quantity of holes is basically equal to the quantity of electrons in the two-dimensional electron gas channel 222 in the gate region 1001, and there is no problem that activation of holes in an Mg doping technology needs to be precisely controlled. In addition, because there is no p-GaN layer, there is no problem of a defect state caused by Mg diffusion. In addition, a threshold voltage of the component is determined by a structure of the gate region 1001, and a process window is large. Therefore, there is no problem that the threshold voltage is sensitive to Mg doping concentration and a p-GaN activation condition.

Specifically, the barrier layer 231&232 may include a first part 231 facing the gallium nitride layer 220 and a second part 232 facing the gate 251. The first part 231 is formed in the gate region 1001 and the non-gate region 1002, and a projection of the second part 232 on the surface of the gallium nitride layer 220 is located in the gate region. In other words, the second part 232 is formed in the first part 231 of the gate region 1001, and it may be considered that the second part 232 is formed in the gate region 1001. Aluminum concentration in the first part 231 is greater than aluminum concentration in the second part 232, and correspondingly, gallium concentration in the first part 231 is greater than gallium concentration in the second part 232. Because the second part 232 is formed in the gate region 1001, in the gate region 1001, aluminum components are reduced from the first part 231 to the second part 232. A part having lower aluminum components has a lower barrier height. Therefore, a low barrier between the part with the lower aluminum components and the gallium nitride layer 220. In this structure, the aluminum components are reduced from the first part 231 to the second part 232. Because a polarization effect generates a hole in the first part 231 and the second part 232, the barrier layer 231&232 in the gate region 1001 may be naturally equivalent to p-type doping without Mg doping, a quantity of holes is basically equal to a quantity of electrons in a two-dimensional electron gas channel 222 in the gate region 1001, and the electrons in the two-dimensional electron gas channel 222 may be naturally exhausted.

In this embodiment of this application, a mole ratio of aluminum to gallium in the barrier layer located in the non-gate region is greater than or equal to 3/7. In other words, a mole ratio of aluminum to gallium in the first part 231 is greater than or equal to 3/7, that is, x1≥30%. Therefore, the first part 231 has a high barrier height, and can effectively generate a two-dimensional electron gas. A size (namely, a vertical size) of the first part 231 (namely, the barrier layer in the non-gate region 1002) in the direction perpendicular to the surface of the gallium nitride layer 220 may be less than or equal to 30 nm, for example, may be 5 nm. When the aluminum gallium nitride layer is in the size range, a two-dimensional electron gas channel in the gate region 1001 is easily exhausted.

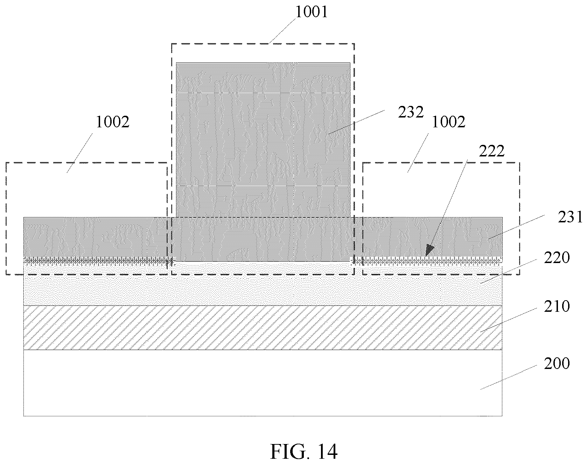

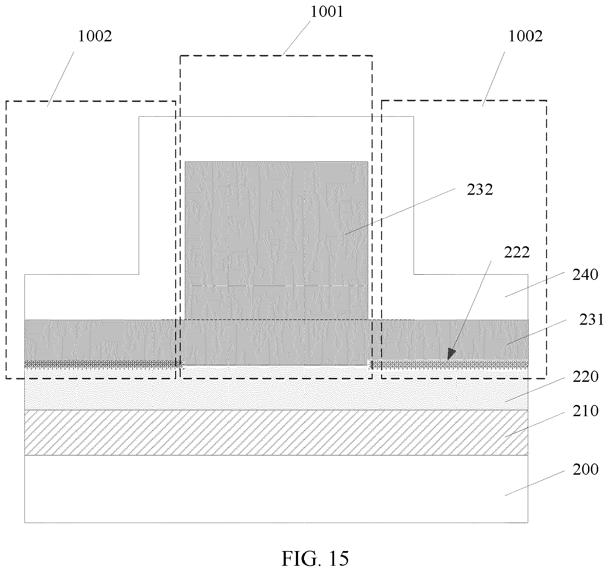

In an implementation of forming the barrier layer 231&232 and the gate, an aluminum gallium nitride material layer 230 may be first formed on a surface of a side of the gallium nitride layer 220, as shown in FIG. 13, and then the aluminum gallium nitride material layer 230 located in the non-gate region 1002 is etched to reduce a thickness to obtain the barrier layer. The barrier layer may include the first part 231 and the second part 232, the first part 231 is located in the gate region 1001 and the non-gate region 1002, and the second part 232 is located in the gate region 1001, as shown in FIG. 14. Then, the gate 251 is formed on a side that is of the barrier layer located in the gate region 1001 and that is away from the gallium nitride layer 220, as shown in FIG. 15 to FIG. 17, FIG. 4, and FIG. 9. Elements of a constituent material of the aluminum gallium nitride material layer 230 include aluminum, gallium, and nitrogen. Aluminum concentration on a side that is of the aluminum gallium nitride material layer 230 and that faces the gallium nitride layer 220 is greater than aluminum concentration on a side that is of the aluminum gallium nitride material layer 230 and that is away from the gallium nitride layer 220.

Specifically, the aluminum concentration on the side that is of the aluminum gallium nitride material layer 230 and that faces the gallium nitride layer 220 is high, and the aluminum content on the side that is of the aluminum gallium nitride material layer 230 and that is away from the gallium nitride layer 220 is low. The entire aluminum gallium nitride material layer 230 may be an integrated structure without an obvious boundary, or may include a plurality of sub-film layers. Specifically, when the aluminum gallium nitride material layer 230 is of an integrated structure, the aluminum gallium nitride material layer 230 may be obtained by using a same deposition process. In a deposition process, aluminum concentration at different thicknesses may be adjusted by separately adjusting deposition rates of aluminum and gallium. Therefore, etching the aluminum gallium nitride material layer 230 in the non-gate region 1002 is equivalent to thinning a part region of the aluminum gallium nitride material layer 230. After thinning, a part that still covers the gate region 1001 and the non-gate region 1002 is used as the first part 231, and a part located in the gate region 1001 is used as the second part 232. For ease of description, a sub-interface is set for the first part 231 and the second part 232. The sub-interface is a plane on which an upper surface of the first part 231 is located, and is represented as a horizontal dashed line in FIG. 14. A same expression manner is used in a subsequent schematic diagram of a structure.

The formed barrier layer 231&232 has a large thickness in the gate region 1001, and has a small thickness in the non-gate region 1002. A thickness of the barrier layer 231&232 in the non-gate region 1002 is equal to a thickness of the first part 231, and a thickness of the barrier layer 231&232 in the gate region 1001 is equal to a sum of the thickness of the first part 231 and the thickness of the second part 232, as shown in FIG. 14. The aluminum gallium nitride material layer 230 may be formed in the MOCVD manner. The aluminum gallium nitride material layer 230 may be etched by using a photoetching process. An etching manner may be anisotropic dry etching. A thickness of the etching may be controlled by using an etching rate and etching duration.

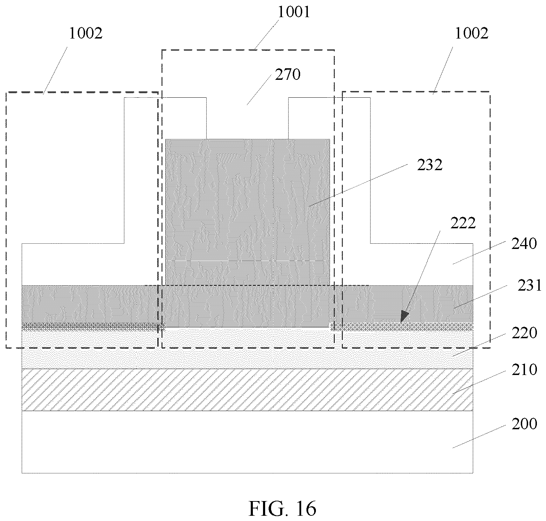

In some possible implementations, after the barrier layer 231&232 are formed, a passivation layer 240 may be further formed on a surface of the barrier layer in the non-gate region 1002 to generate stress, so that a two-dimensional electron gas channel 222 in the first part 231 is regenerated, which helps implement a channel with a high charge transfer rate. A material of the passivation layer 240 may be at least one of silicon nitride and aluminum carbide. In this case, that the gate 251 on the side that is of the barrier layer and located in the gate region 1001 and that is away from the gallium nitride layer 220 is formed may be specifically: forming the passivation layer 240 covering the barrier layer; as shown in FIG. 15, etching the passivation layer 240 covering the barrier layer in the gate region 1001, to form a gate hole 270 that penetrates the passivation layer 240; and as shown in FIG. 16, forming the gate 251 in the gate hole 270. The formed passivation layer 240 covers the first part 231 and the second part 232, for example, covers a side wall of the second part 232, or may cover a part of an upper surface of the second part 232, as shown in FIG. 4.

The gate 251 may include a first gate structure and a second gate structure that are electrically connected. The first gate structure is located in the gate hole and penetrates the passivation layer 240. The second gate structure is formed on a side that is of the first gate structure and that is away from the substrate 200, and covers a part of a surface of the passivation layer 240. In other words, the gate 251 may form a "T"-shaped structure, to improve lead-out reliability of the gate 251. The first gate structure and the second gate structure may be formed by deposition and etching. Specifically, a conductor material may be deposited, so that the conductor material fills the gate hole 270 and covers above the gate hole 270. The conductor material may be at least one of: nickel, titanium, aluminum, palladium, platinum, gold, titanium nitride, tantalum nitride, and copper. Then, a conductor material outside the gate region 1001 may be removed, to form a gate located in the gate region 1001. Certainly, the gate 251 may alternatively include only the first gate structure that penetrates the passivation layer 240.

The gate 251 may be in direct contact with the second part 232 to form a Schottky gate component structure. As shown in FIG. 4, compared with a solution in which the gate 251 is in contact with the first part 231, a solution in which the gate 251 is in contact with the second part 232 reduces a forward leakage current of the component. A gate dielectric layer 260 may also be formed between the gate 251 and the second part 232 of the barrier layer, to form an insulated gate component structure. As shown in FIG. 9, the gate dielectric layer 260 is in contact with the second part 232. Compared with a solution in which the gate dielectric layer 260 is in contact with the first part 231 with higher aluminum concentration and the gate dielectric layer 260 is in direct contact with the first part 231 with higher aluminum concentration, a solution in which the gate 251 is in contact with the gate dielectric layer 260 and the gate dielectric layer 260 is in contact with the second part 232 reduces an interface defect and improves threshold stability of the component.

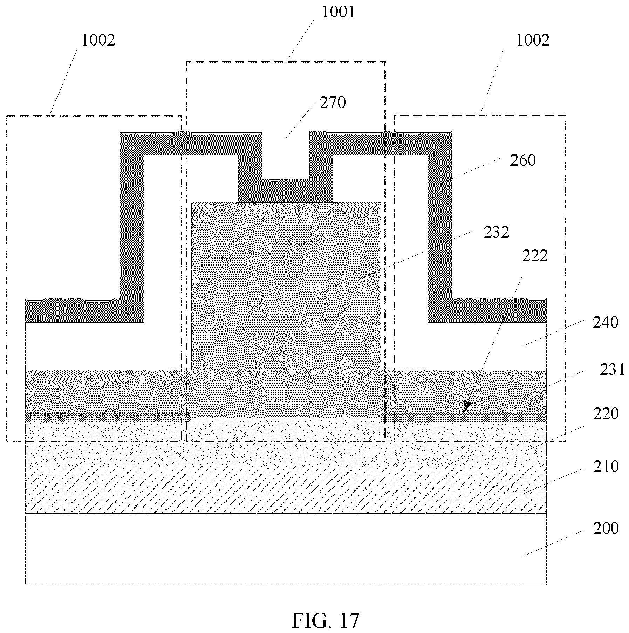

In a manufacturing process of an insulated gate component, before the gate 251 is formed, the gate dielectric layer 260 may be formed between the second part 232 and the gate 251. Specifically, a gate medium material layer 262 may be formed on the aluminum gallium nitride material layer 230. When the aluminum gallium nitride material layer 230 located in the non-gate region 1002 is etched, the gate medium material layer 262 located on the aluminum gallium nitride material layer 230 in the non-gate region 1002 is also etched, to form the gate dielectric layer 260 located in the gate region 1001. The gate dielectric layer 260 is located between the gate 251 and the barrier layer, the passivation layer 240 is formed on the gate dielectric layer 260, and the gate dielectric layer 260 is exposed to the gate hole 270 obtained by etching the passivation layer 240. Specifically, after the gate hole 270 is formed, the gate dielectric layer 260 may be formed through deposition. The gate dielectric layer 260 covers the passivation layer 240, and covers a side wall and a bottom of the gate hole 270. As shown in FIG. 17, the gate 251 is formed in the gate hole 270, as shown in FIG. 9.

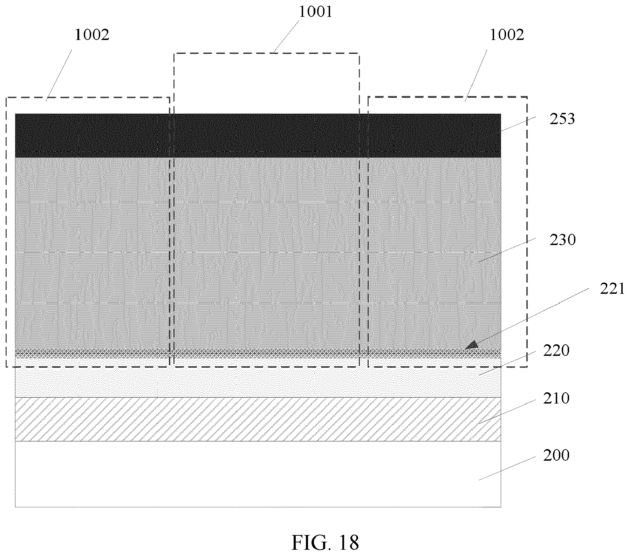

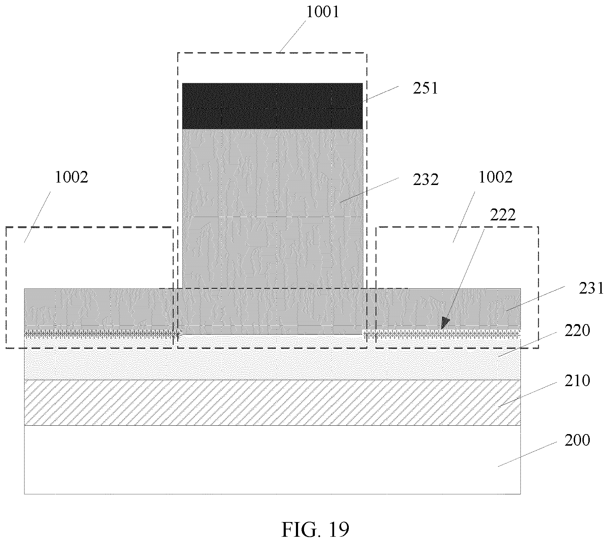

In another implementation of forming the barrier layer 231&232 and the gate, the aluminum gallium nitride material layer 230 may be formed on a surface of a side of the gallium nitride layer 220, and s gate material layer 253 located on a side that is of the aluminum gallium nitride material layer 230 and that is away from the gallium nitride layer 220 may be formed, as shown in FIG. 18. The gate material layer 253 located on a side that is of the aluminum gallium nitride material layer 230 and that is away from the gallium nitride layer in the non-gate region 1002 is etched, and the aluminum gallium nitride material layer 230 located in the non-gate region is etched to reduce a thickness. In other words, the gate material layer 253 and the aluminum gallium nitride material layer 230 are etched in the non-gate region 1002, to obtain the barrier layer 231&232 and the gate 251 on a side that is of the barrier layer located in the gate region 1001 and that is away from the gallium nitride layer 220. The barrier layer includes the second part 232 located in the gate region 1001, and the first part 231 located in the gate region 1001 and the non-gate region 1002, as shown in FIG. 19 to FIG. 21, FIG. 8, and FIG. 10. Elements of a constituent material of the aluminum gallium nitride material layer 230 include aluminum, gallium, and nitrogen. Aluminum concentration on a side that is of the aluminum gallium nitride material layer 230 and that faces the gallium nitride layer 220 is greater than aluminum concentration on a side that is of the aluminum gallium nitride material layer 230 and that is away from the gallium nitride layer 220. A material of the gate material layer 253 may be at least one of: nickel, titanium, aluminum, palladium, platinum, gold, titanium nitride, tantalum nitride, and copper.

Specifically, aluminum concentration of a part that is of the aluminum gallium nitride material layer 230 and that faces the gallium nitride layer 220 is high, and aluminum concentration of a part that is of the aluminum gallium nitride material layer 230 and that is away from the gallium nitride layer 220 is low. The entire aluminum gallium nitride material layer 230 may be an integrated structure, or may include a plurality of film layers. Specifically, when the aluminum gallium nitride material layer 230 is of an integrated structure, the aluminum gallium nitride material layer 230 may be obtained by using a same deposition process. In a deposition process, aluminum concentration at different thicknesses may be adjusted by separately adjusting deposition rates of aluminum and gallium. Therefore, etching the aluminum gallium nitride material layer 230 in the non-gate region 1002 is equivalent to thinning a part region of the aluminum gallium nitride material layer 230. After thinning, a part that still covers the gate region 1001 and the non-gate region 1002 is used as the first part 231, and a part located in the gate region 1001 is used as the second part 232. For ease of description, a sub-interface is set for the first part 231 and the second part 232. The sub-interface is a plane on which an upper surface of the first part 231 is located, and is represented as a horizontal dashed line in FIG. 19. The formed barrier layer 231&232 has a large thickness in the gate region 1001, and has a small thickness in the non-gate region 1002. A thickness of the barrier layer 231&232 in the non-gate region 1002 is equal to a thickness of the first part 231, and a thickness of the barrier layer 231&232 in the gate region 1001 is equal to a sum of the thickness of the first part 231 and the thickness of the second part 232, as shown in FIG. 19.

The gate 251 may be in direct contact with the second part 232 to form a Schottky gate component structure. As shown in FIG. 8, compared with a solution in which the gate 251 is in contact with the first part 231, a solution in which the gate 251 is in contact with the second part 232 reduces a forward leakage current of the component. A gate dielectric layer 260 may also be formed between the gate 251 and the second part 232, to form an insulated gate component structure. As shown in FIG. 10, compared with a solution in which the gate dielectric layer 260 is in contact with the first part 231 with higher aluminum concentration and the gate dielectric layer 260 is in direct contact with the first part 231 with higher aluminum concentration, a solution in which the gate 251 is in contact with the gate dielectric layer 260 and the gate dielectric layer 260 is in contact with the second part 232 reduces an interface defect and improves threshold stability of the component.

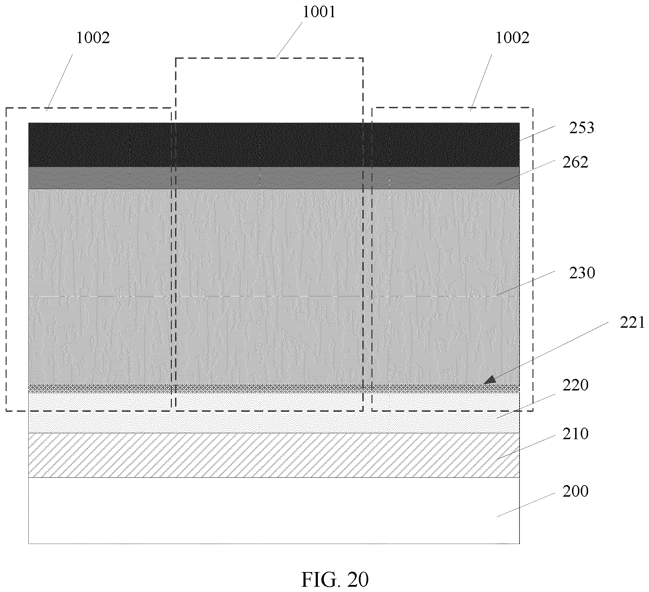

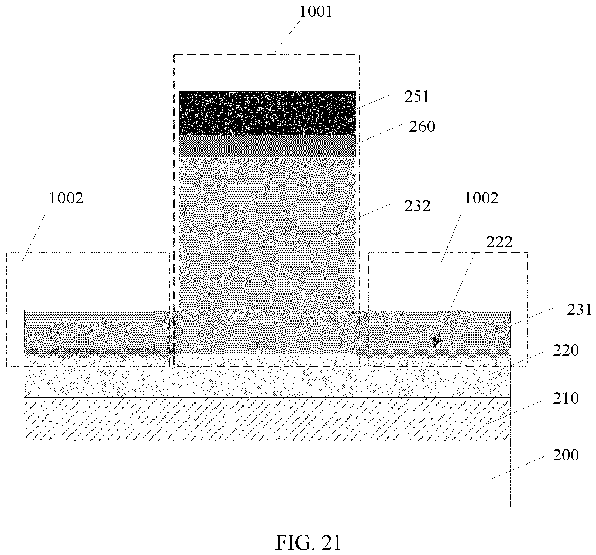

In a manufacturing process of the insulated gate component, the gate medium material layer 262 between the aluminum gallium nitride material layer 230 and the gate material layer 253 may be further formed. As shown in FIG. 20, when the gate material layer 253 on the side that is of the aluminum gallium nitride material layer located in the non-gate region 1002 and that is away from the gallium nitride layer is etched, and the aluminum gallium nitride material layer 230 located in the non-gate region is thinned, the gate medium material layer 262 on the side that is of the aluminum gallium nitride material layer and located in the non-gate region 1002 and that is away from the gallium nitride layer may be etched at the same time, to obtain the gate dielectric layer 260 located in the gate region 1001. The gate dielectric layer 260 is located between the barrier layer 231&232 and the gate 251, as shown in FIG. 21.

In some possible implementations, after the barrier layer 231&232 are formed, the passivation layer 240 may be further formed on a surface (namely, a surface of the first part 231) of the barrier layer in the non-gate region 1002 to generate stress, so that a two-dimensional electron gas channel 222 in the first part 231 is regenerated, which helps implement a channel with a high charge transfer rate. A material of the passivation layer 240 may be at least one of silicon nitride and aluminum carbide. In this case, after the gate 251 is formed, the passivation layer 240 covering the barrier layer 231 and the barrier layer 232 may be formed. As shown in FIG. 8 and FIG. 10, the passivation layer 240 covers a side wall of the second part 232 and an upper surface of the first part 231.

In this embodiment of this application, that the aluminum concentration in the first part 231 is greater than the aluminum concentration in the second part 232 may be reflected as that average aluminum concentration in the first part 231 is greater than average aluminum concentration in the second part 232, and the aluminum concentration in the second part 232 may be uniform or uneven. Specifically, the second part 232 may include a plurality of laminated sub-film layers, and the plurality of sub-film layers are laminated in the vertical direction. Aluminum concentration of the plurality of sub-film layers may not be exactly the same. Aluminum concentration of sub-film layers facing the gate 251 is less than aluminum concentration of sub-film layers facing the first part 231. In other words, aluminum concentration of upper sub-film layers may be less than aluminum concentration of lower sub-film layers. In this way, the aluminum concentration sequentially decreases from a side facing the first part 231 to a side away from the first part 231, and aluminum concentration of each sub-film layer presents a decreasing trend, so that the aluminum concentration decreases in a stepwise manner, and the polarization effect in the barrier layer 231&232 in the gate region 1001 is enhanced. Specifically, the second part 232 may alternatively be an integrated structure without an obvious boundary, that is, there may be no obvious sudden change in aluminum content in the second part 232, and the aluminum concentration of the second part 232 presents a descending trend from the side facing the first part 231 to the side away from the first part 231. The descending trend may be continuous and uniform decline, or may be non-uniform decline. As shown in FIG. 6B, aluminum concentration at different film layer heights inside the first part 231 is the same, and the aluminum concentration of the second part 232 decrease at a uniform speed from the side facing the first part 231 to the side away from the first part 231.

In this embodiment of this application, a source 252 and a drain 253 may further be formed on the barrier layer in the non-gate region 1002. To be specific, the source 252 and the drain 253 are formed on the first part 231, and are respectively located on two sides of the gate 251. The source 252 and the drain 253 may be formed on the surface of the first part 231, or may be formed in a through hole obtained by etching the first part 231. A material of the source 252 and/or the drain 253 is at least one of: nickel, titanium, aluminum, palladium, platinum, gold, titanium nitride, tantalum nitride, and copper.

An embodiment of this application provides a method for manufacturing a gallium nitride component, to obtain a gallium nitride layer. The gallium nitride layer has a gate region and a non-gate region outside the gate region, a barrier layer is formed on a surface of a side of the gallium nitride layer, and a gate is located on a side that is of the barrier layer in the gate region and that is away from the gallium nitride layer. Elements of a constituent material of the barrier layer include aluminum, gallium, and nitrogen. The barrier layer is located in the gate region and the non-gate region. In a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate. In this way, the aluminum concentration in the barrier layer decreases in a direction of the gate region away from the gallium nitride layer, and based on a polarization effect, the barrier layer can be naturally equivalent to p-type doping without Mg doping, so that electrons at an AlGaN/GaN interface in the gate region can be naturally exhausted, and a two-dimensional electron gas channel in the non-gate region is not exhausted. In addition, when a normally-closed gallium nitride component is formed, a defect state is not formed in the barrier layer in the non-gate region due to the Mg doping. Therefore, a risk of dynamic resistance degradation and resistance degradation after HTOL of the component is reduced, and the gallium nitride component with excellent performance is obtained.

Based on the gallium nitride component provided in embodiments of this application, an embodiment of this application further provides an electronic device. The electronic device includes a circuit board and a gallium nitride component connected to the circuit board. The gallium nitride component may be any gallium nitride component provided above. The circuit board may be a printed circuit board (PCB). Certainly, the circuit board may alternatively be a flexible circuit board (FPC), and the like. The circuit board is not limited in this embodiment. Optionally, the electronic device is different types of user equipment or terminal devices such as a computer, a mobile phone, a tablet computer, a wearable device, and a vehicle-mounted device. The electronic device may alternatively be a network device such as a base station.

Optionally, the electronic device further includes a package substrate. The package substrate is fastened on the printed circuit board PCB by using a solder ball, and the gallium nitride component is fastened on the package substrate by using the solder ball.

In another aspect of this application, a non-transitory computer-readable storage medium used with a computer is further provided. The computer has software for creating a gallium nitride component, the computer-readable storage medium stores one or more computer-readable data structures, and the one or more computer-readable data structures have light mask data for manufacturing the gallium nitride component provided in any one of the foregoing figures.

Embodiments in this specification are all described in a progressive manner, for same or similar parts in embodiments, reference may be made to these embodiments, and each embodiment focuses on a difference from other embodiments.

The foregoing provides specific implementations of this application. It should be understood that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A gallium nitride component, comprising:
a gallium nitride layer, wherein the gallium nitride layer has a gate region and a non-gate region outside the gate region;
a barrier layer, wherein the barrier layer is located on a surface of a side of the gallium nitride layer, and elements of a constituent material of the barrier layer comprise aluminum, gallium, and nitrogen; and
a gate, wherein the gate is located on a side that is of the barrier layer in the gate region and that is away from the gallium nitride layer, wherein
the barrier layer is located in the gate region and the non-gate region; and in a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate.

2. The gallium nitride component according to claim 1, wherein the barrier layer comprises a first part facing the gallium nitride layer and a second part facing the gate, aluminum concentration of the first part is greater than aluminum concentration of the second part, the first part is located in the gate region and the non-gate region, and a projection of the second part on the surface of the gallium nitride layer is located in the gate region.

3. The gallium nitride component according to claim 2, wherein the first part is a first film layer, the second part comprises a plurality of laminated sub-film layers, and aluminum concentration of sub-film layers facing the gate is less than aluminum concentration of sub-film layers facing the first part.

4. The gallium nitride component according to claim 2, wherein the aluminum concentration of the second part presents a descending trend from a side facing the first part to a side away from the first part.

5. The gallium nitride component according to any one of claims 1 to 4, wherein in the direction perpendicular to the surface of the gallium nitride layer, the size of the barrier layer located in the non-gate region is less than or equal to 30 nm.

6. The gallium nitride component according to any one of claims 2 to 5, wherein a mole ratio of aluminum to gallium in the barrier layer located in the non-gate region is greater than or equal to 3/7.

7. The gallium nitride component according to any one of claims 1 to 6, further comprising:
a source and a drain, wherein the source and the drain are located on a side that is of the barrier layer in the non-gate region and that is away from the gallium nitride layer.

8. The gallium nitride component according to claim 7, wherein a material of at least one of the source, the drain, and the gate is at least one of: nickel, titanium, aluminum, palladium, platinum, gold, titanium nitride, tantalum nitride, and copper.

9. The gallium nitride component according to any one of claims 1 to 8, further comprising:
a passivation layer, wherein the passivation layer covers the barrier layer located in the non-gate region.

10. The gallium nitride component according to claim 9, wherein the passivation layer further covers the barrier layer located in the gate region, the gate comprises a first gate structure and a second gate structure that are electrically connected, the first gate structure penetrates the passivation layer, and the second gate structure is formed on a side that is of the first gate structure and that is away from the gallium nitride layer, and covers a part of a surface of the passivation layer.

11. The gallium nitride component according to claim 9 or 10, wherein a material of the passivation layer is at least one of silicon nitride and aluminum carbide.

12. The gallium nitride component according to any one of claims 1 to 11, further comprising:
a gate dielectric layer located between the barrier layer and the gate.

13. The gallium nitride component according to any one of claims 1 to 12, further comprising:
a substrate, located on a side that is of the gallium nitride layer and that is away from the barrier layer.

14. The gallium nitride component according to claim 13, further comprising:
a buffer layer located between the substrate and the gallium nitride layer.

15. A method for manufacturing a gallium nitride component, comprising:
obtaining a gallium nitride layer, wherein the gallium nitride layer has a gate region and a non-gate region outside the gate region; and
forming a barrier layer on a surface of a side of the gallium nitride layer, and a gate located on a side that is of the barrier layer in the gate region and that is away from the gallium nitride layer, wherein elements of a constituent material of the barrier layer comprise aluminum, gallium, and nitrogen, the barrier layer is located in the gate region and the non-gate region, and in a direction perpendicular to the surface of the gallium nitride layer, a size of the barrier layer located in the gate region is greater than a size of the barrier layer located in the non-gate region, and aluminum concentration on a side that is of the barrier layer located in the gate region and that faces the gallium nitride layer is greater than aluminum concentration on a side that is of the barrier layer located in the gate region and that faces the gate.

16. The method according to claim 15, wherein the barrier layer comprises a first part facing the gallium nitride layer and a second part facing the gate, aluminum concentration of the first part is greater than aluminum concentration of the second part, the first part is located in the gate region and the non-gate region, and a projection of the second part on the surface of the gallium nitride layer is located in the gate region.

17. The method according to claim 16, wherein the first part is a first film layer, the second part comprises a plurality of laminated sub-film layers, and aluminum concentration of sub-film layers facing the gate is less than aluminum concentration of sub-film layers facing the first part.

18. The method according to claim 16, wherein the aluminum concentration of the second part presents a descending trend from a side facing the first part to a side away from the first part.

19. The method according to any one of claims 15 to 18, wherein in the direction perpendicular to the surface of the gallium nitride layer, the size of the barrier layer located in the non-gate region is less than or equal to 30 nm.

20. The method according to any one of claims 15 to 19, wherein a mole ratio of aluminum to gallium in the barrier layer located in the non-gate region is greater than or equal to 3/7.

21. The method according to any one of claims 15 to 20, further comprising:
forming a source and a drain on a side that is of the barrier layer in the non-gate region and that is away from the gallium nitride layer.

22. The method according to claim 21, wherein a material of at least one of the source, the drain, and the gate is at least one of: nickel, titanium, aluminum, palladium, platinum, gold, titanium nitride, tantalum nitride, and copper.

23. The method according to any one of claims 15 to 22, wherein the forming a barrier layer on a surface of a side of the gallium nitride layer, and a gate located on a side that is of the barrier layer in the gate region and that is away from the gallium nitride layer comprises:
forming an aluminum gallium nitride material layer on the surface of the side of the gallium nitride layer, wherein elements of a constituent material of the aluminum gallium nitride material layer comprise aluminum, gallium, and nitrogen, and aluminum concentration on a side that is of the aluminum gallium nitride material layer and that faces the gallium nitride layer is greater than aluminum concentration on a side that is of the aluminum gallium nitride material layer and that is away from the gallium nitride layer;
thinning the aluminum gallium nitride material layer located in the non-gate region, to obtain the barrier layer; and
forming the gate on the side that is of the barrier layer located in the gate region and that is away from the gallium nitride layer.

24. The method according to claim 23, wherein the forming the gate on the side that is of the barrier layer located in the gate region and that is away from the gallium nitride layer comprises:
forming a passivation layer covering the barrier layer; and
etching the passivation layer that covers the barrier layer in the gate region, to form a gate hole that penetrates the passivation layer, and form the gate in the gate hole.

25. The method according to claim 24, wherein the gate comprises a first gate structure and a second gate structure that are electrically connected, the first gate structure is located in the gate hole, and the second gate structure is formed on a side that is of the first gate structure and that is away from the gallium nitride layer, and covers a part of a surface of the passivation layer.

26. The method according to any one of claims 23 to 25, before the forming the gate, the method further comprises:
forming a gate dielectric layer between the barrier layer and the gate.

27. The method according to any one of claims 15 to 22, wherein the forming a barrier layer on a surface of a side of the gallium nitride layer, and a gate located on a side that is of the barrier layer in the gate region and that is away from the gallium nitride layer comprises:
forming an aluminum gallium nitride material layer on the surface of the side of the gallium nitride layer, and a gate material layer located on a side that is of the aluminum gallium nitride material layer and that is away from the gallium nitride layer, wherein elements of a constituent material of the aluminum gallium nitride material layer comprise aluminum, gallium, and nitrogen, and aluminum concentration on a side that is of the aluminum gallium nitride material layer and that faces the gallium nitride layer is greater than aluminum concentration on a side that is of the aluminum gallium nitride material layer and that is away from the gallium nitride layer; and
etching the gate material layer located on a side that is of the aluminum gallium nitride material layer in the non-gate region and that is away from the gallium nitride layer, and thinning the aluminum gallium nitride material layer located in the non-gate region, to obtain the barrier layer and the gate located on the side that is of the barrier layer in the gate region and that is away from the gallium nitride layer.

28. The method according to claim 27, further comprising:
forming a gate medium material layer between the aluminum gallium nitride material layer and the gate material layer; and
when the gate material layer located on the side that is of the aluminum gallium nitride material layer in the non-gate region and that is away from the gallium nitride layer is etched, and the aluminum gallium nitride material layer located in the non-gate region is thinned, further etching the gate medium material layer located on the side that is of the aluminum gallium nitride material layer in the non-gate region and that is away from the gallium nitride layer, to obtain a gate dielectric layer located between the barrier layer and the gate.

29. The method according to claim 27 or 28, wherein after the forming the barrier layer, the method further comprises:
forming a passivation layer covering the barrier layer.

30. The method according to any one of claims 24, 25, and 29, wherein a material of the passivation layer is at least one of silicon nitride and aluminum carbide.

31. The method according to any one of claims 15 to 30, wherein a substrate is disposed on a side that is of the gallium nitride layer and that is away from the barrier layer.

32. The method according to claim 31, wherein a buffer layer is disposed between the gallium nitride layer and the substrate.

33. An electronic device, comprising a circuit board, and the gallium nitride component according to any one of claims 1 to 14 connected to the circuit board.
